# EUROPEAN PATENT SPECIFICATION

(11) **EP 4 429 014 B1**
(45) Date of publication and mention of the grant of the patent: **03.06.2026**
(21) Application number: 23875163.0
(22) Date of filing: 27.09.2023
(51) Int. Cl.: H01M 50/569, H01M 50/502, H01M 50/141, H01M 50/211, H01M 10/42, H01M 10/48, H01M 50/503

(54) **ELECTROLYTE LEAKAGE DETECTION UNIT USING INSULATION RESISTANCE, AND BATTERY MODULE COMPRISING SAME**
ELEKTROLYTLECKDETEKTIONSEINHEIT MIT ISOLATIONSWIDERSTAND UND BATTERIEMODUL DAMIT
UNITÉ DE DÉTECTION DE FUITE D'ÉLECTROLYTE UTILISANT UNE RÉSISTANCE D'ISOLATION, ET MODULE DE BATTERIE LA COMPRENANT

(30) Priority: 04.10.2022 KR 20220126496
(43) Date of publication of application: 11.09.2024
(73) Proprietor: LG Energy Solution, Ltd., Seoul 07335 (KR)
(72) Inventor: OH, Kyu Hwan, Daejeon 34122 (KR); LEE, Won Tae, Daejeon 34122 (KR); HWANG, Sung Tack, Daejeon 34122 (KR)
(74) Representative: Plasseraud IP
(86) International application number: PCT/KR2023/014970
(87) International publication number: WO 2024/076099

(56) References cited:
- EP-A1- 3 872 889
- EP-A1- 4 224 596
- JP-A- 2002 251 985
- JP-A- 2016 001 525
- JP-A- 2019 185 861
- KR-A- 20210 024 917
- KR-A- 20210 108 269
- KR-B1- 102 340 898
- US-A1- 2020 067 145
- US-A1- 2020 067 145

## Description

### [Technical Field]

The present invention relates to an electrolyte leakage detection unit using insulation resistance and a battery module including the same. More particularly, the present invention relates to a detection unit disposed in a battery module or a battery pack, the detection unit being configured to detect leakage of an electrolyte from a battery cell using insulation resistance, and a battery module or a battery pack including the detection unit.

### [Background Art]

A secondary battery is constituted by a battery module including a plurality of battery cells connected to each other in series and/or in parallel or a battery pack including battery modules connected to each other depending on required output voltage or charge and discharge capacities.

A pouch-shaped battery having a stacked type or stacked and folded type electrode assembly mounted in a pouch-shaped battery case made of a laminate sheet has been mainly used in a battery module or a battery pack due to low manufacturing cost and high energy density thereof.

For the pouch-shaped battery, a laminate sheet including an outer covering layer, a metal barrier layer, and an inner adhesive layer is shaped so as to be used as a battery case. An electrode assembly and an electrolyte are received in a receiving portion formed in the laminate sheet, and the laminate sheet is sealed, whereby the pouch-shaped battery is manufactured.

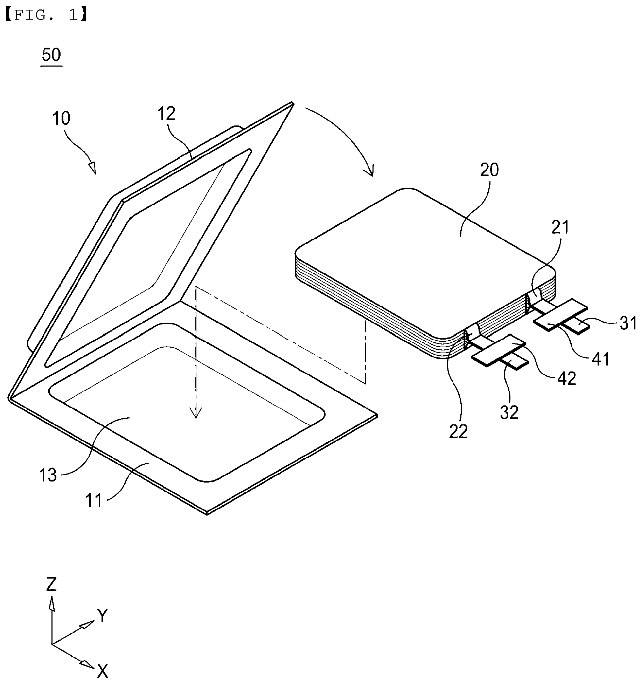

As shown in FIG. 1, a pouch-shaped battery 50 is configured such that an electrode assembly 20 is mounted in a receiving portion 13 of a battery case 10 constituted by a pouch-shaped lower part 11 and a pouch-shaped upper part 12. Positive electrode and negative electrode tabs 21 and 22 of the electrode assembly 20 are welded respectively to two electrode leads 31 and 32, which are exposed out of the battery case 10. An outer periphery of the battery case 10 is sealed in the state in which a pair of insulating films 41 is provided on upper and lower surfaces of the electrode lead 31 and a pair of insulating films 42 is provided on upper and lower surfaces of the electrode lead 32.

FIG. 1 shows the case in which the positive electrode and negative electrode tabs 21 and 22 are located in the same direction by way of example. That is, in FIG. 1, the positive electrode and negative electrode tabs 21 and 22 are located only in a +x direction of a plane parallel to a yz plane of the electrode assembly 20. When the positive electrode and negative electrode tabs 21 and 22 are located in different directions of the electrode assembly 20, i.e., when the positive electrode and negative electrode tabs are located respectively in +x and -x directions of the plane parallel to the yz-plane of the electrode assembly 20 in FIG. 1, a folded edge of the battery case, i.e., a folded edge located along a y-axis in FIG. 1, is rotated in a counterclockwise direction and is located in a plane located along an x-axis.

A pouch-shaped battery configured such that electrode tabs are located at opposite sides of an electrode assembly is mainly used in a battery module or a battery pack. A plurality of pouch-shaped batteries, in each of which a positive electrode tab and a negative electrode tab are provided respectively at opposite sides thereof, is vertically disposed to constitute a pouch-shaped battery cell assembly, and busbars configured to electrically connect the positive electrode tabs and the negative electrode tabs, specifically positive electrode leads and the negative electrode leads, to each other are disposed at opposite ends of the pouch-shaped battery cell assembly. The busbars disposed at the opposite ends of the pouch-shaped battery cell assembly may be electrically connected to each other.

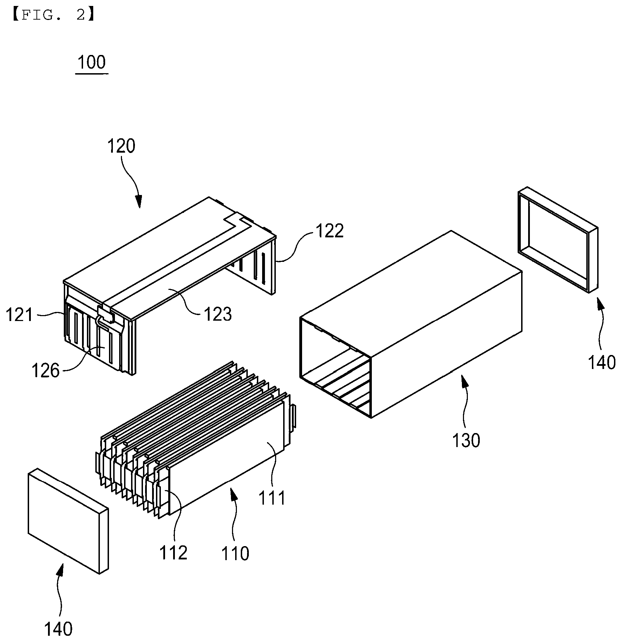

FIG. 2 is an exploded perspective view schematically showing the structure of a conventional battery module 100. Referring to FIG. 2, the battery module 100 includes a pouch-shaped battery cell assembly 110 constituted by a stack of pouch-shaped battery cells 111, each of which has bidirectional electrode leads 112, a busbar frame 120 constituted by a first vertical plate 121 and a second vertical plate 122 disposed respectively at opposite side surfaces of the pouch-shaped battery cell assembly 110 so as to correspond to the position of the electrode leads 112 of the pouch-shaped battery cells 111 and an upper plate 123 connected to the first vertical plate 121 and the second vertical plate 122, the upper plate being disposed above the pouch-shaped battery cell assembly 110, and a monoframe 130 formed in the shape of a square pipe, into an inner space of which the pouch-shaped battery cell assembly 110 having the busbar frame 120 mounted thereto is inserted. A side frame 140 is then coupled to the monoframe 130, whereby the battery module 100 is completed.

A busbar 126 is disposed at each of the first vertical plate 121 and the second vertical plate 122. The busbar 126 is configured to connect the plurality of pouch-shaped battery cells 111 to each other in series or in parallel. The busbar 126 is a conductor having low impedance and high current capacity, and a plurality of busbars 126 is disposed side by side in a direction in which the plurality of pouch-shaped battery cells 111 is stacked to connect the pouch-shaped battery cells 111 to each other in series or in parallel.

Although the busbar 126 is shown as a plate structure having a uniform thickness by way of example, the present invention is not limited thereto, and change to various structures capable of achieving electrical connection is possible.

In addition to the pouch-shaped battery, a cylindrical battery or a prismatic battery may also constitute a battery module or a battery pack. A plurality of cylindrical batteries or a plurality of prismatic batteries may be vertically disposed, and a busbar may be disposed at upper surfaces or lower surfaces of the batteries at which electrodes are disposed.

After the battery cells and the busbar are connected to each other, a case configured to fix the battery cells and the busbar may be separately added to the outside.

When each of the pouch-shaped battery, the cylindrical battery, and the prismatic battery is used in a battery module or a battery pack, leakage of an electrolyte from the battery cell may cause various problems. Leakage of the electrolyte may degrade the electrical performance of the battery module or the battery pack, and there is a danger of corrosion, short circuit, and fire outbreak due to leaked electrolyte. For a battery module having a plurality of battery cells mounted therein, early electrolyte leakage detection is very important for safety reasons.

Patent Document 1 relates to an apparatus and method for detecting leakage of an electrolyte from a battery cell to protect a battery pack. Patent Document 1 includes an electrolyte absorbing member 10 attached to the outside of a battery cell to absorb an electrolyte having leaked from the battery cell, the electrolyte absorbing member having characteristics of a conductor as the result of absorbing the electrolyte, a power supply unit 20 connected to opposite ends of the electrolyte absorbing member to supply power thereto, a resistance unit 30 connected between the electrolyte absorbing member and the power supply unit, a sensing unit 40 configured to sense whether current flows in the resistance unit, and a controller 50 configured to melt and cut a fuse on a charging and discharging path of the battery pack to block charging and discharging current when the sensing unit senses that current flows in the resistance unit.

Patent Document 1 has the feature of detecting leakage of the electrolyte, thereby protecting a battery module or a battery pack; however, the overall structure of absorbing the electrolyte and sensing whether current flows is very complicated. In particular, the electrolyte absorption member must be attached separately to the outside of each battery cell, and there is a problem that a plurality of additional members takes up space and reduces energy density.

Patent Document 2 relates to a battery module and a battery pack including the same, wherein a film-type sensor configured to detect leakage of an electrolyte is attached to opposite sides of a slit in a busbar frame. An insulating coating layer, which is made of a material configured to melt when reacting with an organic solvent, i.e., an electrolyte, is added to the outside of the film-type sensor.

In the case of Patent Document 2, when the electrolyte leaks, the electrolyte moves to a lower end of the bus frame by gravity, whereby it is difficult to detect leakage of the electrolyte unless the electrolyte leaks in large quantities. Rather, the leaked electrolyte escapes through the slit, making early detection difficult.

In addition, electrical connection is required for each individual position at which the sensor is attached, whereby the structure for such electrical connection is complicated, and interference with a busbar may be caused due to electrical connection.

Patent Document 3 relates to an apparatus for detecting leakage of an electrolyte in a battery module/pack, wherein a wire parallel to a strip body including a wiring portion is embedded in a lower part of the battery module/pack, and a wire window is configured to cause a capillary effect to short-circuit two wires in case of leakage of an electrolyte, and a determination is made as to whether an electrolyte leaks from a battery through electrical resistance measurement.

In the case of Patent Document 3, the wiring portion configured to detect the electrolyte is embedded in a separate bottom plate, and therefore and detection is possible only when the amount of the leaked electrolyte reaches a certain amount. In Patent Document 3, it is stated that detection is possible only when the amount of the leaked electrolyte exceeds 8 ml.

It is difficult to apply a battery module or pack using a pouch-shaped battery to Patent Document 3. Since a lower surface of the pouch-shaped battery is a part that is connected without separate sealing, an electrolyte leaks from a side surface or an upper surface of the pouch-shaped battery. When the electrolyte leaks from the upper surface of the pouch-shaped battery, the electrolyte cannot flow to the bottom plate and is dried before that unless the electrolyte leaks in large quantities, since pouch-shaped battery cells are stacked vertically, the distance therebetween is very small, and a pad may be added therebetween in some cases.

In Patent Document 3, separate embedment in the bottom plate is required, and a configuration, such as a capillary, must be added. When embedment is performed in a longitudinal direction, as in an embodiment of Patent Document 3, early detection of leakage of the electrolyte from the pouch-shaped battery is substantially impossible.

If the electrolyte leaks from opposite sides of the pouch-shaped battery, i.e., the parts of the pouch-shaped battery from which electrode tabs protrude, the electrolyte leaks to the lower end of the busbar frame, and the electrolyte must leak in significant quantities in order for the electrolyte to flow to the separate bottom plate.

Patent Document 3 mentions the case in which a strip-type detection groove is installed in the center of the bottom plate or is disposed along electrodes of the batteries in the battery module so as to be located directly under the electrodes, and also mentions the case in which a plurality of strip-type detection grooves is provided. In Patent Document 3, however, the shape of the strip-type detection groove is limited. In the case of a pouch-shaped battery, opposite electrodes must be coupled to the busbar frame, and therefore the strip-type detection groove of Patent Document 3 may be located only under the busbar frame. In this case, early detection of a very small amount of an electrolyte is impossible. Patent Document 3 also limits the minimally detectable amount of the electrolyte to more than 8 ml.

It can be seen that, in the embodiment of Patent Document 3 or when the strip-type detection groove is disposed under the electrode, early detection of leakage of the electrolyte from the pouch-shaped battery is impossible. Given that the strip-type detection groove of Patent Document 3 is described as being disposed in the longitudinal direction, being disposed directly under the electrode, or being disposed in plural, it may be assumed that the case in which a cylindrical battery cell is used is considered.

Patent Document 4 relates to a storage device capable of performing early detection of abnormality of a storage element (leakage of an electrolyte). In Patent Document 4, the storage device 1 has a plurality of storage elements 10 each containing an electrolyte, the storage elements being configured to be charged and discharged, and a holder 30 configured to hold each of the plurality of storage elements in a predetermined plane (in an Y-Z plane) in an insulated state. The holder has conductive members 31 and 34 exposed outward from the holder, wherein the conductive member is located with respect to each storage element in a direction in which the electrolyte is discharged from each storage element. The conductive member is coupled to a sensor 100 configured to detect the conduction state and the non-conduction state of the conductive member.

In Patent Document 4, leakage of the electrolyte is detected by measuring insulation resistance, but detection is possible only when the electrolyte leaks in large amounts.

As can be seen from the above, technology that i) is capable of performing early detection of leakage of a very small amount of an electrolyte, ii) is simple in structure, and iii) is capable of being applied without interference with the configuration of a conventional device has not yet been provided.

### (Prior Art Documents)

(Patent Document 1) Korean Registered Patent Publication No. 1383599 (2014.04.03)
(Patent Document 2) Korean Patent Application Publication No. 2021-0108269 (2021.09.02)
(Patent Document 3) Chinese Patent Application Publication No. 111337201 (2020.06.26)
(Patent Document 4) Japanese Patent Application Publication No. 2014-63663 (2014.04.10)

### [Disclosure]

### [Technical Problem]

The present invention has been made in view of the above problems, and it is an object of the present invention to provide an electrolyte leakage detection unit that i) is capable of performing early detection of leakage of a very small amount of an electrolyte, ii) is simple in structure, and iii) is capable of being applied without interference with the configuration of a conventional device and a battery module including the same.

### [Technical Solution]

A battery module according to the present invention to accomplish the above object includes a battery cell (60); a vertical plate (200) including a busbar (126) configured to allow an electrode of the battery cell (60) to be electrically coupled thereto; and an outer frame (300) configured to surround the vertical plate (200) and the outside of the battery cell (60); at least one electrical connection unit (270) extending through the vertical plate (200), the electrical connection unit being electrically connected to the outer frame (300); and a detection unit (330) configured to measure insulation resistance or voltage of one terminal electrode of the battery module and the outer frame (300).

Also, in the battery module according to the present invention, the vertical plate (200) may include a vertical support portion (220) disposed vertically, an electrode groove (240) formed by a plurality of slits provided in a part of the vertical support portion (220) in a vertical direction, the electrode groove being configured to allow the electrode of the battery cell to extend therethrough, a busbar (126) coupled to the electrode of extending through the electrode groove (240), and a lower end support portion (260) coupled to the vertical support portion (220) along a lower perimeter of the vertical support portion, the lower end support portion being formed in the shape of a horizontal band.

Also, in the battery module according to the present invention, the electrical connection unit (270) may include at least one vertical connection portion (272) extending through the lower end support portion (260) and electrically connected to one end of the outer frame (300) and an upper surface connection portion (271) electrically connected to the vertical connection portion (271) and exposed on an upper surface of the lower end support portion (260) or disposed on the upper surface of the lower end support portion (260).

Also, in the battery module according to the present invention, the electrical connection unit (270) may include at least one outer frame connection portion (273) electrically connected to one end of the outer frame (300) and an upper surface connection portion (271) electrically connected to the outer frame connection portion (273) and exposed on an upper surface of the lower end support portion (260) or disposed on the upper surface of the lower end support portion (260).

Also, in the battery module according to the present invention, the upper surface connection portion (271) may be disposed spaced apart from the battery cell (60) in a non-contact state.

Also, in the battery module according to the present invention, when an electrolyte (280) leaks from the battery cell (60), the upper surface connection portion (271) may be electrically connected to the battery cell (60) via the leaked electrolyte (280).

Also, in the battery module according to the present invention, the upper surface connection portion (271) may be located at a lower part at which the electrode of the battery cell (60) is disposed.

Also, in the battery module according to the present invention, each of the upper surface connection portion (271) and the vertical connection portion (272) may be made of a conductor.

Also, in the battery module according to the present invention, the upper surface connection portion (271) may be a metal band formed in the shape of a thin plate and may be located at the upper surface of the lower end support portion (260) at which the electrode of the battery cell (60) is disposed.

Also, in the battery module according to the present invention, the vertical connection portion (272) may be located and fixed at one side or opposite sides of the upper surface connection portion (271).

Also, in the battery module according to the present invention, the upper surface connection portion may be circular and may be disposed at the upper surface of the lower end support portion (260) at which the electrode of the battery cell (60) is disposed in a state of being spaced apart from each other.

Also, in the battery module according to the present invention, the outer frame connection portion (273) may be an electric wire configured to electrically connect the upper surface connection portion (271) and the outer frame (300) to each other.

In addition, an electrolyte leakage detection method according to the present invention includes measuring insulation resistance or voltage of the outer frame (300) and determining that the electrolyte has leaked when the measured insulation resistance or voltage deviates from a reference range.

The present invention may provide any possible combinations of the above solving means.

### [Advantageous Effects]

As is apparent from the above description, in the present invention, it is possible to provide an electrolyte leakage detection unit that i) is capable of performing early detection of leakage of a very small amount of an electrolyte, ii) is relatively simple in structure since only insulation resistance or voltage of an outer frame is measured, and iii) is capable of being applied without interference with the configuration of a conventional device and a battery module including the same.

### [Description of Drawings]

FIG. 1 is an exploded perspective view of a conventional pouch-shaped battery.
FIG. 2 is an exploded perspective view schematically showing the structure of a conventional battery module.
FIG. 3 is a perspective view of a pouch-shaped battery cell that is mounted in a battery module according to a preferred embodiment of the present invention.
FIG. 4 is an inner schematic view of a vertical plate of the battery module according to the present invention.
FIG. 5 is an outer schematic view of the vertical plate of the battery module according to the present invention.
FIG. 6 is a schematic view showing a battery module including an outer frame according to the present invention.
FIG. 7 is a side schematic view of an electrical connection unit according to an embodiment of the present invention.
FIG. 8 is a plan schematic view of an electrical connection unit according to another embodiment of the present invention.
FIG. 9 is a view showing a detection unit configured to measure insulation resistance of the outer frame according to the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is the to be connected to another part in the entire specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, an electrolyte leakage detection unit according to the present invention and a battery module including the same will be described with reference to the accompanying drawings.

The basic structure of the battery module according to the present invention is identical to the structure of a battery module using a conventional pouch-shaped battery. FIG. 2 is an exploded perspective view schematically showing the structure of a conventional battery module. Unlike FIG. 2, the pouch-shaped battery may be modified to have electrodes disposed in only one direction as shown in FIG. 1, and upper ends of a busbar frame 120 may not be connected to each other.

Even in the case of a pouch-shaped battery having electrodes disposed in opposite directions, the shape of the busbar frame 120 is not limited to the shape shown in the figure, and the busbar frame may have any shape as long as opposite busbars are electrically connected to each other. Furthermore, a monoframe 130 and a side frame 140, which are shown as one example, may be modified into any shape as long as the monoframe and the side frame serve as an outer case configured to enclose the battery module.

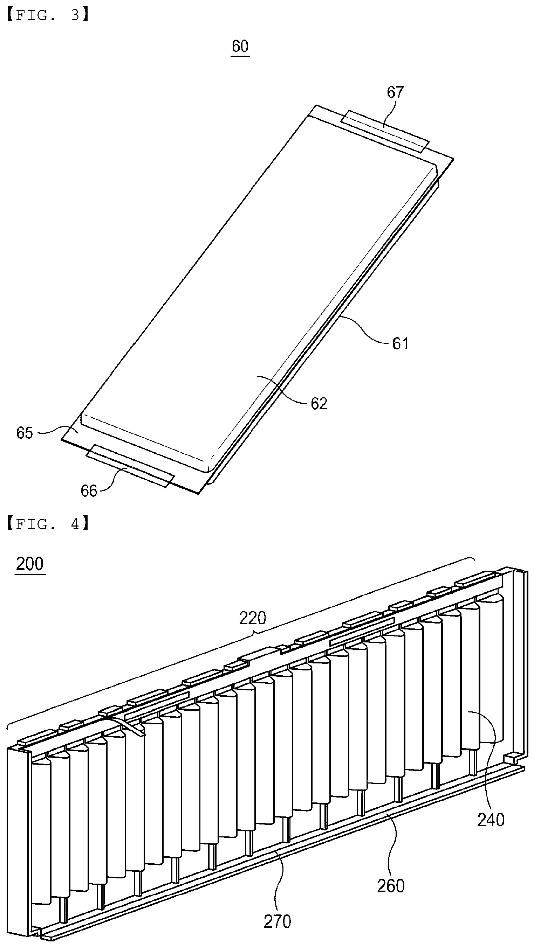

FIG. 3 is a perspective view of a battery cell that is mounted in a battery module according to an embodiment of the present invention.

As shown in FIG. 3, the pouch-shaped battery or battery cell 60 includes a cell case upper part 62, a cell case lower part 61, an electrode assembly (not shown) received in the cell case upper part and the cell case lower part, a sealed portion 65 provided at edges of the cell case upper part and the cell case lower part, a pair of electrode tabs (not shown), a pair of electrode leads constituted by a positive electrode lead 66 and a negative electrode lead 67, each of which has one side electrically connected to a corresponding one of the electrode tabs and the other side protruding outward from the cell case, and an insulating film (not shown).

Specifically, each of the cell case upper part 62 and the cell case lower part 61 is provided with a pocket-shaped space portion, in which the electrode assembly is received.

The space portion of the cell case, in which the electrode assembly is received, is formed using a laminate sheet constituted by an outer covering layer, a metal layer, and an inner covering layer.

The inner covering layer is disposed in direct contact with the electrode assembly, and therefore the inner covering layer must exhibit high insulation properties and high resistance to an electrolyte. In addition, the inner covering layer must exhibit high sealability in order to hermetically isolate the cell case from the outside, i.e., a thermally-bonded sealed portion between inner layers must exhibit excellent thermal bonding strength.

The inner covering layer may be made of a material selected from among a polyolefin-based resin, such as polypropylene, polyethylene, polyethylene acrylic acid, or polybutylene, a polyurethane resin, and a polyimide resin, which exhibit excellent chemical resistance and high sealability; however, the present invention is not limited thereto, and polypropylene, which exhibits excellent mechanical properties, such as tensile strength, rigidity, surface hardness, and impact resistance, and excellent chemical resistance, is preferably used.

The metal layer, which abuts the outer covering layer, corresponds to a barrier layer configured to prevent moisture or various kinds of gas from permeating into the battery from the outside. An aluminum thin film, which is lightweight and easily shapeable, may be used as a preferred material for the metal layer.

The outer covering layer is provided at an outer surface of the metal layer, and the outer covering layer may be made of a heat-resistant polymer that exhibits excellent tensile strength, resistance to moisture permeation, and resistance to air transmission such that the outer covering layer exhibits high heat resistance and chemical resistance while protecting the electrode assembly. As an example, the outer covering layer may be made of nylon or polyethylene terephthalate; however, the present invention is not limited thereto.

The electrode assembly, which is received in the cell case upper part 62 and the cell case lower part 61, may be classified as a stacked type electrode assembly, which is configured to have a structure in which a plurality of electrodes is stacked, a jelly-roll type electrode assembly, which is configured to have a structure in which a positive electrode and a negative electrode are wound in the state in which a separator is interposed therebetween, a laminated and stacked type electrode assembly, which is configured to have a structure in which a plurality of unit cells is stacked, or a stacked and folded type electrode assembly, which is configured to have a structure in which unit cells are wound in a state of being located on a separator sheet.

A unit cell is manufactured in order to manufacture the laminated and stacked type electrode assembly or the stacked and folded type electrode assembly, wherein the unit cell may be a mono-cell, which is configured to have a structure in which a separator is interposed between a positive electrode and a negative electrode, or a bi-cell, which is configured to have a structure in which a positive electrode, a negative electrode, and a positive electrode or a negative electrode, a positive electrode, and a negative electrode are stacked and a separator is interposed between the positive electrode and the negative electrode.

The electrode assembly according to the present invention may have a structure in which a negative electrode, a separator, a positive electrode, a separator, and a negative electrode are stacked, and the number of positive electrodes or negative electrodes constituting the electrode assembly may be freely changed. In addition, a laminated and stacked type electrode assembly, in which a plurality of unit cells is laminated, may be used. The structure of the electrode assembly described above may be applied to all electrode assemblies described in this specification.

A positive electrode tab and a negative electrode tab are provided respectively at the positive electrode and the negative electrode of the electrode assembly, and the pair of electrode tabs is disposed so as to protrude a predetermined length outward from the cell case in a state of being connected respectively to a positive electrode lead 66 and a negative electrode lead 67 by spot welding, etc.

The insulating film is located at an upper surface and a lower surface of each of the pair of electrode leads, more specifically at the sealed portion 65, at which the cell case upper part 62 and the cell case lower part 61 are thermally fused to each other. The insulating film prevents electricity generated by the electrode assembly from flowing to the cell case via the electrode leads and maintains a sealed state between the electrode leads and the cell case. The insulating film is preferably made of a non-conductive material that does not conduct electricity well, and an insulating tape easy to attach to the electrode leads while having a relatively small thickness is generally used; however, the present invention is not limited thereto.

Although the battery cell is shown as a bidirectional battery cell having a positive electrode lead 66 and a negative electrode lead 67 located at opposite ends thereof in the figure, the present invention may also be applied to a unidirectional battery cell having a pair of electrode leads disposed so as to face in the same direction.

During use of the battery module, separation of the thermally fused sealed portion of the pouch-shaped battery may occur due to repeated charging and discharging, i.e., the thermally fused portion may be deteriorated due to expansion pressure caused by gas generated by irreversible reaction or due to repetition of the conditions using high current such as rapid charging, whereby an electrolyte may leak from the pouch-shaped battery.

In addition, the electrolyte may leak due to a variety of reasons, such as tear of the case by external impact or chemical corrosion.

Since a lower surface of the pouch-shaped battery, which is vertically disposed in the battery module, is a part that is connected without separate sealing, the electrolyte leaks from a side surface or an upper surface of the pouch-shaped battery. When the electrolyte leaks from the upper surface of the pouch-shaped battery, the electrolyte cannot flow to the bottom plate and is dried before that unless the electrolyte leaks from the upper surface of the pouch-shaped battery in large quantities, since the battery cells are stacked vertically, the distance therebetween is very small, and a pad may be added therebetween in some cases.

If the electrolyte leaks from opposite sides of the pouch-shaped battery, i.e., the parts of the pouch-shaped battery from which the electrode tabs protrude, the electrolyte leaks to a lower end of a busbar frame, and the electrolyte must leak in significant quantities in order for the electrolyte to flow to the separate bottom plate.

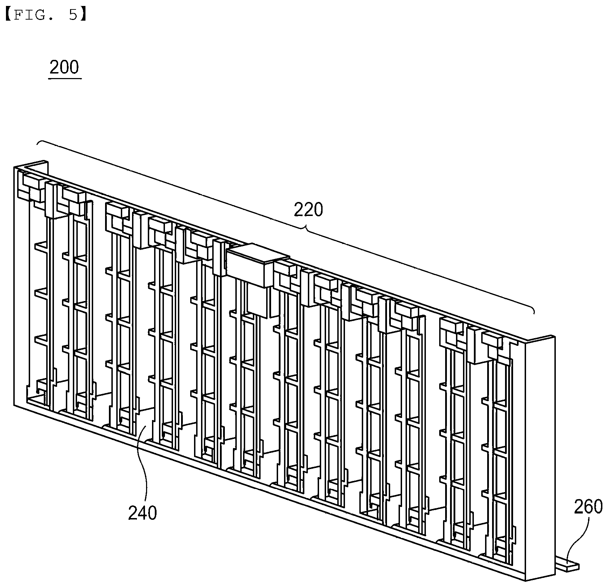

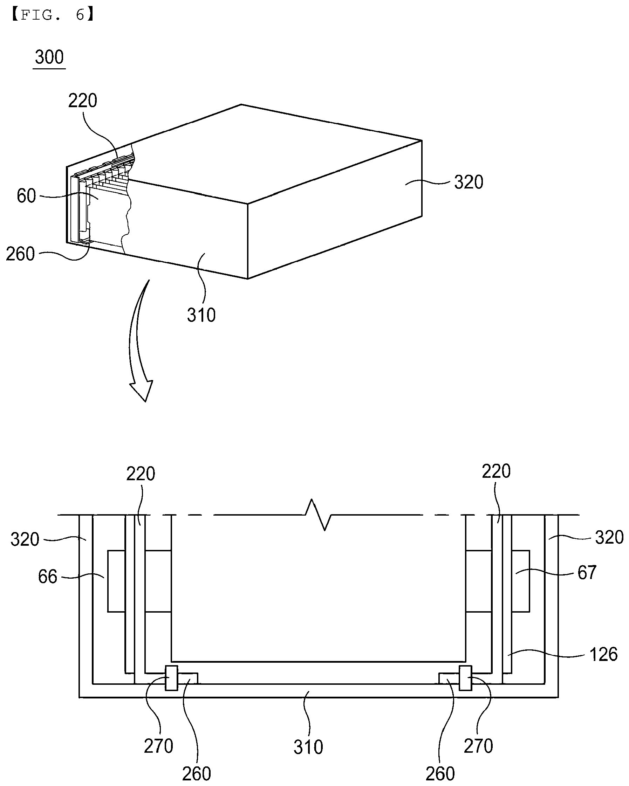

FIG. 4 is an inner schematic view of a vertical plate of the battery module according to the present invention, FIG. 5 is an outer schematic view of the vertical plate of the battery module according to the present invention, and FIG. 6 is a schematic view showing a configuration in which electrodes of a pouch-shaped cell are fastened to a vertical plate 200 and a battery module including an outer frame.

Referring to FIGs. 4 to 6, the vertical plate 200 is disposed at each of left and right sides of a battery assembly of the battery module. A circuit part including a busbar for electrical connection is omitted from the vertical plate 200 of FIGs. 4 to 6.

The vertical plate 200 may include a vertical support portion 220 disposed vertically, an electrode groove 240 formed in the shape of a plurality of slits provided in a part of the vertical support portion 220 in a vertical direction, the electrode groove being configured to allow electrodes of pouch-shaped battery cells to extend therethrough, a busbar (not shown, omitted) coupled to the electrodes extending through the electrode groove 240, and a lower end support portion 260 coupled to the vertical support portion 220 along a lower perimeter thereof, the lower end support portion being formed in the shape of a horizontal band. In addition, the vertical plate 200 may be located on one side, or may be symmetrically located on opposite sides, depending on the shape and position of the electrodes of the battery cell.

The outer frame 300 is a single frame configured to protect the vertical plate 200 and the pouch-shaped battery cell from the outside, and may include a monoframe 310 and a side frame 320; however, the present invention is not limited thereto since the outer frame may be modified so as to have various shapes. The outer frame 300 may be configured in the form of a framework made of metal, unlike the monoframe 310 of FIG. 6, and an electrical connection unit 270, a description of which will follow, may be connected to such a framework type outer frame, in which case a separate cover may be further added. A lower end support portion 260 of the vertical plate 200 is fixed to a lower part of the outer frame 300.

The electrical connection unit 270 according to the present invention is disposed at an upper surface of the lower end support portion 260. In FIG. 4, the electrical connection unit 270 is simplified and shown only as a black line.

Referring to FIG. 6, the electrical connection unit 270 is electrically connected to the monoframe 310, and when an electrolyte leaks from the battery cell, electrical conduction is achieved between the battery cell and the monoframe 310 via the electrical connection unit 270.

In a normal state without electrolyte leakage, a certain distance is maintained between the electrical connection unit 270 and the battery cell, whereby insulation is achieved therebetween and the insulation from the monoframe 310 is also maintained. If the monoframe 310 and the battery cell are electrical conducted to each other due to leakage, however, leakage current may occur, whereby insulation resistance or voltage is changed.

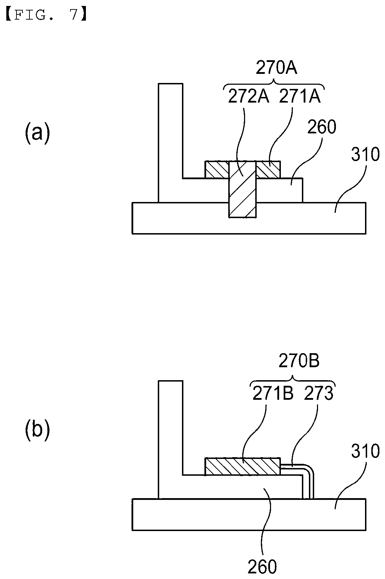

Hereinafter, a specific embodiment of the electrical connection unit 270 and a method of measuring insulation resistance or voltage will be described in detail with reference to FIGs. 7 to 9.

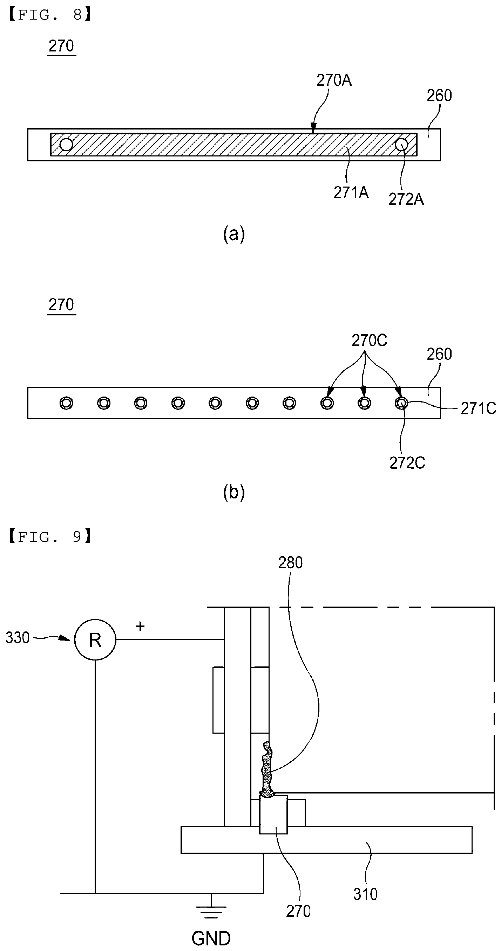

FIG. 7 is a side schematic view of an electrical connection unit 270A or 270B according to an embodiment of the present invention, and FIG. 8 is a plan schematic view of an electrical connection unit 270A or 270C according to another embodiment of the present invention.

Referring to FIG. 7, the electrical connection unit 270A or 270B is constituted by coupling between an upper surface connection portion 271A, which is a conductor, and a vertical connection portion 272A or coupling between an upper surface connection portion 271B and an outer frame connection portion 273, and is spaced apart from the battery cell in a non-contact state by a predetermined distance. Here, the distance may be set such that the electrical connection unit and the battery cell are electrically connected to each other when an electrolyte 280 leaks to the upper surface connection portion 271A or 271B. In addition, the upper surface connection portion 271A or 271B is located at a lower part at which the electrode of the battery cell 60 is disposed.

Specifically, referring to (a) of FIG. 7, the upper surface connection portion 271A is located an upper surface of the lower end support portion 260, and the upper surface connection portion 271A and the monoframe 310 are coupled to each other via the vertical connection portion 272A. Meanwhile, since the vertical connection portion 272A must be fixed to the monoframe 310 through the lower end support portion 260, the vertical connection portion may be configured in the form of a bolt or a rivet; however, the present invention is not limited thereto. The entirety of the electrical connection unit 270A may be configured in the form of a simple cylinder, unlike (a) of FIG. 7.

Referring to (b) of FIG. 7, which shows the electrical connection unit 270B according to the modification of the present invention, the upper surface connection portion 271B is directly connected to the monoframe 310 via the outer frame connection portion 273 without the vertical connection portion 272A, wherein the outer frame connection portion may be a wire or flexible flat cable (FFC) electrically connected to one surface of the monoframe 310; however, the present invention is not limited thereto. At this time, the upper surface connection portion 271B may be fixed to the lower end support portion 260 by adhesion.

FIG. 8 is a plan view showing the electrical connection unit 270A located at the upper surface of the lower end support portion 260 of FIG. 7.

Referring to (a) of FIG. 8, the upper surface connection portion 271A is configured as a metal band formed in the shape of a thin plate and is located at the upper surface of the lower end support portion 260, and each end of the upper surface connection portion is fixed by the vertical connection portion 272A. Here, the position of the vertical connection portion 272A is not particularly limited since it is sufficient for the vertical connection portion 272A to be connected to the upper surface connection portion 271A so as to be electrically connected to the monoframe 310. In (a) of FIG. 8, the upper surface connection portion 271A may be modified such that the upper surface connection portion is divided into a plurality of parts, at each of which the vertical connection portion 272A is provided.

Referring to (b) of FIG. 8, an upper surface connection portion 271C is integrally formed with a vertical connection portion 272C, and is disposed directly under a pouch of the battery cell in one or more. In addition, the upper surface connection portion 271C may have various shapes, preferably a circular shape.

FIG. 9 is a view showing a detection unit 330 configured to measure insulation resistance or voltage of the monoframe 310 according to the present invention.

Referring to FIG. 9, the detection unit 330 measures insulation resistance or voltage between the monoframe 310 connected to ground and an external electrode of a pouch-shaped battery cell. When measurement is performed at 500 volts for 60 seconds until leakage occurs, an insulation resistance of approximately several hundred megohms (Mohms) or more is measured. When an electrolyte 280 leaks, however, electrical conduction occurs between the upper surface connection portion 271 and the battery cell, which leads to a decrease in insulation resistance or an increase in voltage. The detection unit 330 configured to detect insulation resistance or voltage may be included in a BMS of a module or a BMS of a battery pack, which is not shown in FIG. 9.

In addition, when the electrolyte 280 leaks from a plurality of pouch-shape battery cells, leakage current is generated in proportion to the number of electrically conducted pouch-shape battery cells, whereby insulation resistance is further reduced. The degree of leakage of the electrolyte 280 may be detected based on a decreased resistance value relative to a reference insulation resistance value.

### (Description of Reference Symbols)

10: Battery case
11, 61: Lower parts
12, 62: Upper parts
13: Receiving portion
20: Electrode assembly
21, 22: Electrode tabs
31, 32, 66, 67: Electrode leads
41, 42: Insulating films
50, 60: Pouch-shaped batteries
65: Sealed portion
100: Battery module
110: Cell assembly
111: Pouch-shaped battery
112: Electrode lead
120: Busbar frame
121, 122: Vertical plates
123: Upper plate
126: Busbar
130, 310: Monoframes
140, 320: Side frames
200: Vertical plate
220: Vertical support portion
240: Electrode groove
260: Lower end support portion
270, 270A, 270B, 270C: Electrical connection units
271A, 271B, 271C: Upper surface connection portions
272A, 272C: Vertical connection portions
273: Outer frame connection portion
280: Electrolyte
300: Outer frame
330: Detection unit

## Claims

1. A battery module comprising:
a battery cell (60);
a vertical plate (200) comprising a busbar (126) configured to allow an electrode (66, 67) of the battery cell (60) to be electrically coupled thereto; and
an outer frame (300) configured to surround the vertical plate (200) and an outside of the battery cell (60);
**characterized in that** the battery module further comprises:
at least one electrical connection unit (270) extending through the vertical plate (200), the electrical connection unit (270) being electrically connected to the outer frame (300); and
a detection unit (330) configured to measure insulation resistance or voltage of one terminal electrode of the battery module and the outer frame (300).

2. The battery module according to claim 1, wherein the vertical plate (200) comprises:
a vertical support portion (220) disposed vertically;
an electrode groove (240) formed by a plurality of slits provided in a part of the vertical support portion (220) in a vertical direction, the electrode groove (240) being configured to allow the electrode (66, 67) of the battery cell (60) to extend therethrough;
a busbar (126) coupled to the electrode of extending through the electrode groove (240); and
a lower end support portion (260) coupled to the vertical support portion (220) along a lower perimeter of the vertical support portion (220), the lower end support portion (260) being in the shape of a horizontal band.

3. The battery module according to claim 2, wherein the electrical connection unit (270) comprises:
at least one vertical connection portion (272) extending through the lower end support portion (260) and electrically connected to one end of the outer frame (300); and
an upper surface connection portion (271) electrically connected to the vertical connection portion (272) and exposed on an upper surface of the lower end support portion (260) or disposed on the upper surface of the lower end support portion (260).

4. The battery module according to claim 2, wherein the electrical connection unit (270) comprises:
at least one outer frame connection portion (273) electrically connected to one end of the outer frame (300); and
an upper surface connection portion (271) electrically connected to the outer frame connection portion (273) and exposed on an upper surface of the lower end support portion (260) or disposed on the upper surface of the lower end support portion (260).

5. The battery module according to claim 3 or 4, wherein the upper surface connection portion (271) is disposed spaced apart from the battery cell (60) in a non-contact state.

6. The battery module according to claim 3 or 4, wherein, when an electrolyte (280) leaks from the battery cell (60), the upper surface connection portion (271) is electrically connected to the battery cell (60) via the leaked electrolyte (280).

7. The battery module according to claim 3 or 4, wherein the upper surface connection portion (271) is located at a lower part at which the electrode (66, 67) of the battery cell (60) is disposed.

8. The battery module according to claim 3 or 4, wherein each of the upper surface connection portion (271) and the vertical connection portion (272) is made of a conductor.

9. The battery module according to claim 3 or 4, wherein the upper surface connection portion (271) is a metal band formed in the shape of a thin plate and is located at the upper surface of the lower end support portion (260) at which the electrode (66, 67) of the battery cell (60) is disposed.

10. The battery module according to claim 9, wherein the vertical connection portion (272) is located and fixed at one side or opposite sides of the upper surface connection portion (271).

11. The battery module according to claim 3 or 4, wherein the upper surface connection portion (271) is circular and is disposed at the upper surface of the lower end support portion (260) at which the electrode (66, 67) of the battery cell (60) is disposed in a state of being spaced apart from each other.

12. The battery module according to claim 4, wherein the outer frame connection portion (273) is an electric wire configured to electrically connect the upper surface connection portion (271) and the outer frame (300) to each other.

13. A method of detecting leakage of an electrolyte (280) from a battery cell (60) using the battery module according to any one of claims 1 to 12, wherein insulation resistance or voltage of the outer frame (300) is measured, and when the measured insulation resistance or voltage deviates from a reference range, a determination is made that the electrolyte (280) has leaked.

## Patentansprüche

1. Batteriemodul, umfassend:
eine Batteriezelle (60);
eine vertikale Platte (200), umfassend eine Sammelschiene (126), welche dazu eingerichtet ist, zu ermöglichen, dass eine Elektrode (66, 67) der Batteriezelle (60) elektrisch damit gekoppelt ist; und
einen Außenrahmen (300), welcher dazu eingerichtet ist, die vertikale Platte (200) und eine Außenseite der Batteriezelle (60) zu umgeben;
**dadurch gekennzeichnet, dass** das Batteriemodul ferner umfasst:
wenigstens eine elektrische Verbindungseinheit (270), welche sich durch die vertikale Platte (200) erstreckt, wobei die elektrische Verbindungseinheit (270) elektrisch mit dem Außenrahmen (300) verbunden ist; und
eine Detektionseinheit (330), welche dazu eingerichtet ist, einen Isolationswiderstand oder eine Spannung einer Anschlusselektrode des Batteriemoduls und des Außenrahmens (300) zu messen.

2. Batteriemodul nach Anspruch 1, wobei die vertikale Platte (200) umfasst:
einen vertikalen Stützabschnitt (220), welcher vertikal angeordnet ist;
eine Elektrodennut (240), welche durch eine Mehrzahl von Schlitzen gebildet ist, welche in einem Teil des vertikalen Stützabschnitts (220) in einer vertikalen Richtung bereitgestellt sind, wobei die Elektrodennut (240) dazu eingerichtet ist, zu ermöglichen, dass sich die Elektrode (66, 67) der Batteriezelle (60) dahindurch erstreckt;
eine Sammelschiene (126), welche mit der Elektrode gekoppelt ist, welche sich durch die Elektrodennut (240) erstreckt; und
einen unteren Endstützabschnitt (260), welcher mit dem vertikalen Stützabschnitt (220) entlang eines unteren Umfangs des vertikalen Stützabschnitts (220) gekoppelt ist, wobei der untere Endstützabschnitt (260) in der Form eines horizontalen Bandes ist.

3. Batteriemodul nach Anspruch 2, wobei die elektrische Verbindungseinheit (270) umfasst:
wenigstens einen vertikalen Verbindungsabschnitt (272), welcher sich durch den unteren Endstützabschnitt (260) erstreckt und elektrisch mit einem Ende des Außenrahmens (300) verbunden ist; und
einen oberen Flächen-Verbindungsabschnitt (271), welcher elektrisch mit dem vertikalen Verbindungsabschnitt (272) verbunden ist und an einer oberen Fläche des unteren Endstützabschnitts (260) freiliegt oder an der oberen Fläche des unteren Endstützabschnitts (260) angeordnet ist.

4. Batteriemodul nach Anspruch 2, wobei die elektrische Verbindungseinheit (270) umfasst:
wenigstens einen Außenrahmen-Verbindungsabschnitt (273), welcher elektrisch mit einem Ende des Außenrahmens (300) verbunden ist; und
einen oberen Flächen-Verbindungsabschnitt (271), welcher elektrisch mit dem Außenrahmen-Verbindungsabschnitt (273) verbunden ist und an einer oberen Fläche des unteren Endstützabschnitts (260) freiliegt oder an der oberen Fläche des unteren Endstützabschnitts (260) angeordnet ist.

5. Batteriemodul nach Anspruch 3 oder 4, wobei der obere Flächen-Verbindungsabschnitt (271) beabstandet zu der Batteriezelle (60) in einem berührungslosen Zustand angeordnet ist.

6. Batteriemodul nach Anspruch 3 oder 4, wobei, wenn ein Elektrolyt (280) aus der Batteriezelle (60) austritt, der obere Flächen-Verbindungsabschnitt (271) elektrisch mit der Batteriezelle (60) über den ausgetretenen Elektrolyten (280) verbunden ist.

7. Batteriemodul nach Anspruch 3 oder 4, wobei der obere Flächen-Verbindungsabschnitt (271) an einem unteren Teil angeordnet ist, an welchem die Elektrode (66, 67) der Batteriezelle (60) angeordnet ist.

8. Batteriemodul nach Anspruch 3 oder 4, wobei jeder aus dem oberen Flächen-Verbindungsabschnitt (271) und dem vertikalen Verbindungsabschnitt (272) aus einem Leiter hergestellt ist.

9. Batteriemodul nach Anspruch 3 oder 4, wobei der obere Flächen-Verbindungsabschnitt (271) ein Metallband, welches in der Form einer dünnen Platte gebildet ist, und an der oberen Fläche des unteren Endstützabschnitts (260) angeordnet ist, an welcher die Elektrode (66, 67) der Batteriezelle (60) angeordnet ist.

10. Batteriemodul nach Anspruch 9, wobei der vertikale Verbindungsabschnitt (272) an einer Seite oder entgegengesetzten Seiten des oberen Flächen-Verbindungsabschnitts (271) angeordnet und fixiert ist.

11. Batteriemodul nach Anspruch 3 oder 4, wobei der obere Flächen-Verbindungsabschnitt (271) kreisförmig ist und an der oberen Fläche des unteren Endstützabschnitts (260) angeordnet ist, an welcher die Elektrode (66, 67) der Batteriezelle (60) in einem voneinander beabstandeten Zustand angeordnet ist.

12. Batteriemodul nach Anspruch 4, wobei der Außenrahmen-Verbindungsabschnitt (273) ein elektrischer Draht ist, welcher dazu eingerichtet ist, den oberen Flächen-Verbindungsabschnitt (271) und den Außenrahmen (300) elektrisch miteinander zu verbinden.

13. Verfahren zum Detektieren eines Lecks eines Elektrolyts (280) aus einer Batteriezelle (60) unter Verwendung des Batteriemoduls nach einem der Ansprüche 1 bis 12, wobei ein Isolationswiderstand oder eine Spannung des Außenrahmens (300) gemessen wird, und wenn der gemessene Isolationswiderstand oder die Spannung von einem Referenzbereich abweicht, eine Bestimmung gemacht wird, dass der Elektrolyt (280) ausgetreten ist.

## Revendications

1. Module de batterie comprenant :
un élément de batterie (60) ;
une plaque verticale (200) comprenant une barre omnibus (126) configurée pour permettre à une électrode (66, 67) de l'élément de batterie (60) d'être couplée électriquement à celle-ci ; et
un cadre externe (300) configuré pour entourer la plaque verticale (200) et un extérieur de l'élément de batterie (60) ;
**caractérisé en ce que** le module de batterie comprend en outre :
au moins une unité de connexion électrique (270) s'étendant à travers la plaque verticale (200), l'unité de connexion électrique (270) étant connectée électriquement au cadre externe (300) ; et
une unité de détection (330) configurée pour mesurer une résistance ou une tension d'isolement d'une électrode de borne du module de batterie et du cadre externe (300).

2. Module de batterie selon la revendication 1, dans lequel la plaque verticale (200) comprend :
une portion de support verticale (220) disposée verticalement ;
une rainure d'électrode (240) formée par une pluralité de fentes fournies dans une partie de la portion de support verticale (220) dans une direction verticale, la rainure d'électrode (240) étant configurée pour permettre à l'électrode (66, 67) de l'élément de batterie (60) de s'étendre à travers celle-ci ;
une barre omnibus (126) couplée à l'électrode s'étendant à travers la rainure d'électrode (240) ; et
une portion de support d'extrémité inférieure (260) accouplée à la portion de support verticale (220) le long d'un périmètre inférieur de la portion de support verticale (220), la portion de support d'extrémité inférieure (260) étant sous la forme d'une bande horizontale.

3. Module de batterie selon la revendication 2, dans lequel l'unité de connexion électrique (270) comprend :
au moins une portion de connexion verticale (272) s'étendant à travers la portion de support d'extrémité inférieure (260) et connectée électriquement à une extrémité du cadre externe (300) ; et
une portion de connexion de surface supérieure (271) connectée électriquement à la portion de connexion verticale (272) et exposée sur une surface supérieure de la portion de support d'extrémité inférieure (260) ou disposée sur la surface supérieure de la portion de support d'extrémité inférieure (260).

4. Module de batterie selon la revendication 2, dans lequel l'unité de connexion électrique (270) comprend :
au moins une portion de connexion de cadre externe (273) connectée électriquement à une extrémité du cadre externe (300) ; et
une portion de connexion de surface supérieure (271) connectée électriquement à la portion de connexion de cadre externe (273) et exposée sur une surface supérieure de la portion de support d'extrémité inférieure (260) ou disposée sur la surface supérieure de la portion de support d'extrémité inférieure (260).

5. Module de batterie selon la revendication 3 ou 4, dans lequel la portion de connexion de surface supérieure (271) est disposée espacée de l'élément de batterie (60) dans un état sans contact.

6. Module de batterie selon la revendication 3 ou 4, dans lequel, lorsqu'un électrolyte (280) fuit de l'élément de batterie (60), la portion de connexion de surface supérieure (271) est connectée électriquement à l'élément de batterie (60) via l'électrolyte (280) qui fuit.

7. Module de batterie selon la revendication 3 ou 4, dans lequel la portion de connexion de surface supérieure (271) est située au niveau d'une partie inférieure au niveau de laquelle l'électrode (66, 67) de l'élément de batterie (60) est disposée.

8. Module de batterie selon la revendication 3 ou 4, dans lequel chacune de la portion de connexion de surface supérieure (271) et de la portion de connexion verticale (272) est constituée d'un conducteur.

9. Module de batterie selon la revendication 3 ou 4, dans lequel la portion de connexion de surface supérieure (271) est une bande métallique ayant la forme d'une plaque mince et est située au niveau de la surface supérieure de la portion de support d'extrémité inférieure (260) au niveau de laquelle l'électrode (66, 67) de l'élément de batterie (60) est disposée.

10. Module de batterie selon la revendication 9, dans lequel la portion de connexion verticale (272) est située et fixée au niveau d'un côté ou de côtés opposés de la portion de connexion de surface supérieure (271).

11. Module de batterie selon la revendication 3 ou 4, dans lequel la portion de connexion de surface supérieure (271) est circulaire et est disposée au niveau de la surface supérieure de la portion de support d'extrémité inférieure (260) au niveau de laquelle l'électrode (66, 67) de l'élément de batterie (60) est disposée dans un état où elles sont espacées l'une de l'autre.

12. Module de batterie selon la revendication 4, dans lequel la portion de connexion de cadre externe (273) est un fil électrique configuré pour connecter électriquement la portion de connexion de surface supérieure (271) et le cadre externe (300) l'un à l'autre.

13. Procédé de détection d'une fuite d'un électrolyte (280) à partir d'un élément de batterie (60) à l'aide du module de batterie selon l'une quelconque des revendications 1 à 12, dans lequel une résistance ou une tension d'isolement du cadre externe (300) sont mesurées, et, lorsque la résistance ou la tension d'isolement mesurées s'écartent d'une plage de référence, il est déterminé que l'électrolyte (280) a fui.
